# EUROPEAN PATENT APPLICATION

(11) **EP 4 047 502 A1**
(43) Date of publication of application: **24.08.2022**
(21) Application number: 21157635.0
(22) Date of filing: 17.02.2021
(51) Int. Cl.: G06F 30/23, G06F 30/27

(54) **METHOD FOR CLASSIFYING THE TYPE OF A VIBRATIONAL MODE AND REAL-WORLD OBJECT DESIGNED BASED ON A CLASSIFICATION COMPRISING SUCH A METHOD**

(71) Applicant: VOLKSWAGEN AG, 38440 Wolfsburg (DE)
(72) Inventor: Gowarzewski, Maximilian, 10557 Berlin (DE); Kleshchonok, Andrii, 12167 Berlin (DE); Dzerin, Yury, 81373 München (DE); Cesur, Gülce, 81675 München (DE)

(57) **Abstract**

The present invention relates to a method for classifying the type of at least one first vibrational mode of the vibrational modes which are obtained from a simulation of a model of a real-world object under dynamic excitation. The present invention also relates to a real-world object which has been designed at least in part based on a classification comprising a respective method.

## Description

The present invention relates to a method for classifying the type of at least one first vibrational mode of the vibrational modes which are obtained from a simulation of a model of a real-world object under dynamic excitation. The present invention also relates to a real-world object which has been designed at least in part based on a classification comprising a respective method.

Structural modal analysis by Finite Element Method (FEM) simulation has become a key technology in structural dynamics analysis. For example, in the field of mechanical design of objects such as machines or vehicles, especially cars, particular attention is paid already at an early design stage to identify possible vibrations of the object, or parts thereof, which may occur during later use of the object under dynamic excitation.

This is why classification of the different vibrational modes that originate from FEM simulations is a basic task which almost every noise vibration harshness simulation engineer has to perform. However, it is a complicated task to classify the vibrational modes.

US 2015/0363361 A1 discloses that data points of input data are processed by first determining a Laplacian matrix for the data. A spectrum of the Laplacian matrix includes an attractive spectrum of positive eigenvalues, a repulsive spectrum of negative eigenvalues, and a neutral spectrum of zero eigenvalues. An operation for the processing is determined using the Laplacian matrix, using information about the attractive spectrum, the repulsive spectrum, and the neutral spectrum, wherein the information includes the spectra and properties derived from the Spectra. Then, the operation is performed to produce processed data.

However, the quality of the results may still be improved and the process may still be made more efficient.

It is, thus, an object of the present invention to overcome the disadvantages described above with respect to the state of the art. Further it is an object of the present invention to provide means which improve the reliability and quality of the classification of vibrational modes. It is also an object of the present invention to provide real-world objects which are of high quality even under dynamic excitation.

The problem is solved by the invention according to a first aspect in that a method for classifying the type of at least one first vibrational mode of the vibrational modes which are obtained from a simulation of a model of a real-world object under dynamic excitation, the method comprising classifying the first vibrational mode based on data of a plurality of geometric subdomains of the model; wherein the plurality of geometric subdomains of the model comprises one or more first geometric subdomains of a first set of first geometric subdomains and one or more second geometric subdomains of a second set of second geometric subdomains, the first and second set of first and second geometric subdomains, respectively, represent the model in a first and second level of detail; and wherein the data of each geometric subdomain is based at least in part on the results of the simulation.

It is, thus, a surprising finding that an improved classification of vibrational modes can be achieved, if the effect that a vibrational mode of particular type has at certain local points of the model is considered in form of data describing the effect the vibrational mode has in two or more different spatial extents around the respective local points. Considering the spatial extent may provide a better overview of the effects the dynamic excitation has in the different volume domains.

The different spatial extents can be efficiently represented, in that the model is represented by respective sets of geometric subdomains having specific levels of detail of the model. This may comprise that the model is approximated by the different levels of detail in a different way.

Thus, not every single local point available of the model has to be considered for evaluation of the type of the vibrational mode. Instead it is sufficient that effects caused by the dynamic excitation with respect to the geometric subdomains are considered. This may reduce the number of data to be processed for classifying the vibrational mode.

For example, the simulation results may provide data for a plurality of local points of the model. For example, for each of said local points, a displacement value of the local point caused by the dynamic excitation may be obtained from the simulation results. Hence, the simulation may provide information on how certain local points on the model are displaced due to the dynamic excitation. For example, the displacement value for each local point may be provided relative to a position of that local point of the model in a state of equilibrium (i.e. without the dynamic excitation). For example, alternatively or in addition, for each of said local points, a strain energy value of the local point caused by the dynamic excitation may be obtained from the simulation results.

In preferred embodiments the data of each geometric subdomain comprise statistical data of that geometric subdomain. It has been found that the present approach can be implemented in an efficient manner even for a large number of local points, if statistical data is used. This for example allows that raw data of many local points is transformed (e.g. by appropriate calculations) to statistical data of geometric subdomains. If the number of geometric subdomains is smaller than the number of local points for which raw data is available, the number of pieces of information can be reduced.

For example, the statistical data may be obtained (such as calculated) on basis of the simulation results associated with the local points of the model. For example, the data of one or more local points of the model covered by the volume of a respective geometric subdomain may contribute to the statistical data of that geometric subdomain. The data of the local points may be obtained from the simulation. Thus, less amount of data has to be considered for the evaluation purpose.

For example, preferred statistical data of the geometric subdomains may comprise a mean value of displacement. Hence, for a particular geometric subdomain, the values of the displacement of the local points covered by the geometric subdomain may be used to calculate the respective statistical data of that geometric subdomain. For example, for two local points underlying the geometric subdomain, if the displacement of one local point in one direction has the value 2 and the displacement of the other local point in the same direction has the value 8, the mean value of displacement may be (8+2)/2 = 5 in that direction. This may be used as one statistical data of the respective geometric subdomain. Of course, depending on the model, displacement in two or three dimensions can also be addressed likewise.

The information comprised in the raw data of the simulation (e.g. for each of the local points) is in principle still present in the data of the geometric subdomains. However, the raw data can be spatially distributed.

Further, other data than statistical data may be used as well, either additionally or alternatively.

The model is represented, e.g. approximated, by at least two different sets of geometric subdomains having two different levels of detail of the model. Thus, for each local point of the model geometric subdomains from different sets, i.e. from representations of different levels of detail, are available. Hence, different data may be provided for a single local point. This allows to improve the classification results.

Thus, if two sets are provided, each local point of the model may be covered by multiple geometric subdomains, which geometric subdomains may have different spatial extents around the local point. Hence, the effect of the dynamic excitation on that local point may be described by means of different statistical data of the respective geometric subdomains. Incorporating such different views on the local points lead to an improved evaluation of the type of the vibrational mode.

In preferred embodiments the model may be represented by three, four, five or even more different sets of geometric subdomains having a respective number of different levels of detail of the model.

The invention, thus, may help to make it obsolete that a person needs to perform a classification by hand. Automation of the classification is possible with the proposed method.

An automated classification may open the possibilities to automatically amend the simulated model based on the classification, followed by a further simulation so as to iteratively obtain an optimized model and, thus, an optimized real-world object. This can be reliable carried out with the present invention since accurate classification results can be provided with the proposed method.

Hence, a feedback loop could be established, by means of which the design process is iteratively refined based on the classification result.

Automation of the classification may reduce classification errors, especially compared to respective evaluations carried out by hand. This in turn reduces the number of iterations in the design process of the machine, such as a vehicle. Furthermore, also the need for additional prototype testing, including producing and conducting experiments under real-world conditions, can be reduced. This is true because since the classification results are more reliable, double checking the design options which have been made based on the classification results can be avoided. This in turn reduces the development time and saves costs.

Preferably, to do classification, performing simulation is needed. This may comprises solving differentiable equations, that are part of the model definition. Therefore, preferably, both preparing the model and classification are part of modal analysis.

For example, in vehicle body design there are certain Key Performance Indicators (KPIs) in frequency domain. There may be restrictions on frequency that are imposed on the collective and local excitations. When a vehicle is designed, the most important collective and local vibrations are checked to be within certain range. The global vibrational modes preferably should match the frequency range for safe and noiseless driving. Therefore, the vehicle body design may be controlled and then adjusted accordingly by the help of this method.

Generating of geometric subdomain features (e.g. the data of the geometric subdomains) may be time consuming, especially if the number of local points reach few millions. Therefore, parallel CPU algorithm may be applied here. Features generation may be parallelized efficiently.

The geometric subdomain may comprise cubic voxels, or other geometrical structures, which especially are more complicated than cubic voxels, or a combination thereof. The geometric subdomains may be displayed or it may be possible that they can be displayed at least in principle. For example, dividing the model of the real-world object into geometric subdomains may comprise placing a 2D or 3D model, such that main symmetry axis are aligned along a coordinate system; Setting a predefined number of geometric subdomains, such as voxels (especially the number should be the same for all geometrical models under consideration); And in order to classify vibrational modes (especially torsion and/or bending), the geometric subdomains split may be chosen to be more fine in one region of the 3D model than in other regions.

For example, if the 3D model is one of a vehicle, in order to classify vibrational modes (especially torsion and/or bending), the geometric subdomains split may be chosen to be more fine at the vehicle front and back, while the center of the vehicle may have only two (or at least less than for the vehicle front and back) geometric subdomains (e.g. voxels) for roof top and bottom. Of course, for the different representations of different levels of detail, the split may be chosen differently. In principle for every classification task it can be done adaptively and even learn it depending on the final classification problem. For example, when it is needed to determine the vibration modes of the steering wheel, it may be put into a separate geometric subdomain (e.g. voxel) and leave the rest untouched.

Generally, the proposed method may work for every or at least many fields of mode analysis. For example, in aero- and astro-nautical engineering, in aerodynamics, in civil engineering, in medicine and chemistry, here especially vibrational mode analysis of molecules. The present invention may preferably be used in the field of automotive engineering. For example, for designing vehicles such as cars or trucks.

Preferably, a geometric subdomain in the present invention is a 3D cell. However, in preferred embodiments of the present invention, and where applicable, a geometric subdomain may also be a 2D cell. This is true because the invention may be employed for modal analysis of 2D objects as well.

In preferred embodiments, the geometric subdomains of two (of two or more) sets are at least in part different in shape and/or size. This may comprise the situation where each geometric subdomain of one particular set has the same shape and/or size but two geometric subdomains of different sets have different shape and/or size. But also the situation may be comprised, where at least in part the geometric subdomains of one particular set are different in shape and/or size.

For example, the vibrational modes indicated by the results of the simulation can be classified using aspects of the present invention. The number of vibrational modes to be checked that way may reach few dozen per simulation. Types of vibrational modes which may be of particular interest are local modes, global vertical bending modes, global horizontal bending modes and global torsion modes.

For example, the dynamic excitation applied to the model during simulation may represent an external force acting on the model. For example, especially in the field of vehicles, the dynamic excitation may give a rise to local or global modes depending on the frequency. This could be global torsion or bending modes or local vibration of the vehicle parts, such as the steering wheel, the front door, the rear wheel axis, and the like. Preferably, the dynamic excitation comprises a sinusoidal excitation.

The method may be computer-implemented.

In one embodiment it is preferred that the method comprising:
Obtaining, especially from a simulation module, results of the simulation directed to the first vibrational mode present for the simulated model, wherein preferably the simulation results comprise values of one or more predefined parameters of each node of a meshed version of the model for that first vibrational mode;
Obtaining, especially from a first statistic module, for each first geometric subdomain of the first set of first geometric subdomains, one or more first statistical data based on the simulation results, preferably the first statistical data being based on the values of the predefined parameters, as comprised by the simulation results, of the nodes underlying the respective first geometric subdomain;
Obtaining, especially from a second statistic module, for each second geometric subdomain of the second set of second geometric subdomains, one or more second statistical data based on the simulation results, preferably the second statistical data being based on the values of the predefined parameters, as comprised by the simulation results, of the nodes underlying the respective second geometric subdomain;

Forming a feature vector comprising the first statistical data and/or the second statistical data; Processing, especially by a machine learning module, the feature vector to classify the type of the first vibrational mode, wherein preferably the machine learning module comprises at least one trained machine learning model;
and/or

Obtaining, especially from the machine learning module, a classification of the first vibrational mode.

The statistical data of each geometric subdomain may be based on simulation results associated with the nodes underlying that geometric subdomains, the spatial effect of the vibrational mode can be covered in a particularly easy and convenient manner. This is because the proposed method can be carried out based on many existing simulation data obtained from state-of-the-art simulation tools. This means at the same time, that retrofitting of existing simulation or modal analysis tools is, therefore, possible without efforts, as the proposed method may continue seamlessly at the output of the simulation.

The aforementioned local points of the model may correspond to the nodes of the meshed version of the model used in the simulation. Hence, unless otherwise apparent from the context, all aspects discussed herein for the local points may apply also to the nodes, and vice versa.

Although all statistical data may be based on the conventional simulation results, it turned out that the specific type of preparation of the input feature vector, having the statistical data as elements, allows, that a classification can be carried out in a more efficient manner.

For example, the feature vector may comprise the values of the predefined parameters obtained from the simulation for all the nodes of the mesh for a particular vibrational mode. In other words: For each node, a value for each of the predefined parameters can be obtained from the simulation. Preferably the simulation comprises a Finite Element Method (FEM) simulation.

It has been found that using machine learning modules (especially along with or instead of classical algorithms for classification purposes) for carrying out the classification task of vibrational modes in the design process and/or for automation purposes allows to obtain improved classification results.

The machine learning module may achieve an overall improvement with respect to the quality and reliability of the classification results, especially when the proposed feature vector is used instead of conventionally used feature vectors based on the raw data of the simulation.

For example, the proposed feature vector may be passed to a respective machine learning module which has been trained on known feature vectors of that type. The machine learning module then provides a classification of the type of the vibrational modes present for the respective feature vector.

While not bound by any theory, it is assumed that the data referring to the different levels of detail allow the machine learning module that tendencies caused by a vibrational mode on the first detail level can be confirmed or corrected by tendencies caused by that vibrational mode on the second detail level, and vice versa. Hence, an "interaction" between the sets of geometric subdomains may be provided. Or, in other words, an interaction between the two different representations of the model is provided. In addition, possibly, for the machine learning module it may be more beneficial to have information concerning the spatial relations of the effects of the vibrational mode, as particularly provided by the statistical data, rather than individual information about local points, as provided in conventional approaches.

It is therefore of advantage that a respective preparation of the feature vector allows to take improved advantage from the machine learning module in the classification process. This makes the machine learning module a preferred component in the proposed inventive approach.

Here, the "features" (i.e. the elements of the feature vector) refer at least in part to the statistical data of the various geometric subdomains. Of course, apart from the first and/or second statistical data, the feature vector may comprise further data without departing from the scope of the present invention.

It is acknowledged that dependent on the arrangement of the nodes relative to the geometric subdomains, of course, there may be nodes, each of which is an underlying node for more than one first geometric subdomains and/or for more than one second geometric subdomains. In this case, there may be even more statistical data, expressing the effect the vibrational mode has in even more than two different spatial extents around the respective local point.

The meshed version of the model may be viewed together with the representation of the model in form of the geometric subdomains of a particular set. Then, in preferred embodiments, a particular node which is arranged at least in part within the volume enclosed by a particular geometric subdomain (of the particular set) is understood to be a "node underlying the geometric subdomain (of the particular set)". For example, the respective node may be arranged completely within the volume, on a face, on an edge or on a corner, respectively, of the respective geometric subdomain.

In preferred exemplary embodiments, each first geometric subdomain of the first set has at least one underlying node of the nodes of the meshed version of the model and/or each of the nodes of the meshed version of the model underlies at least one first geometric subdomain of the first set.

In preferred exemplary embodiments, each second geometric subdomain of the second set has at least one underlying node of the nodes of the meshed version of the model and/or each of the nodes of the meshed version of the model underlies at least one second geometric subdomain of the second set.

In preferred exemplary embodiments, the values of the predefined parameters of a node which lies on a common face, edge or corner of two or more adjacent geometric subdomains may contribute either fully or proportionally to the statistical data of each of the respective geometric subdomains.

For example, a node within the model may be on a common corner of eight geometric subdomains and the predefined parameter may be the displacement having a value of 16. Then the value of the displacement may contribute either fully to the statistical data of each of the eight geometric subdomains, i.e. with a value of 16, or proportionally to the statistical data of each of the eight geometric subdomains, i.e. with a value of 16/8 = 2.

For example, a node within the model may be on a common edge of four geometric subdomains and the predefined parameter may be the displacement having a value of 16. Then the value of the displacement may contribute either fully to the statistical data of each of the four geometric subdomains, i.e. with a value of 16, or proportionally to the statistical data of each of the eight geometric subdomains, i.e. with a value of 16/4 = 4.

For example, a node within the model may be on a common face of two geometric subdomains and the predefined parameter may be the displacement having a value of 16. Then the value of the displacement may contribute either fully to the statistical data of each of the two geometric subdomains, i.e. with a value of 16, or proportionally to the statistical data of each of the eight geometric subdomains, i.e. with a value of 16/2 = 8.

For the sake of clarity, no units have been indicated for the values. Of course, in preferred embodiments, a proportionally contribution may also comprise different weights. Then, the contribution of a node to the different subdomains may be weighted.

A mesh is a representation of a larger geometric domain (such as the model of the real-world object) by smaller discrete 2D or 3D cells. Meshes are commonly used to compute solutions of partial differential equations, such as in FEM simulations. A mesh partitions space into elements over which the equations can be solved, which then approximates the solution over the larger domain. Element boundaries may be constrained to lie on internal or external boundaries within a model. A set of geometric subdomains may be considered as a special type of a mesh.

A module, such as the simulation module, the first statistic module, the second statistic module or the machine learning module, in the present invention may be realized in software, in hardware, or a combination thereof. A module in the present invention may alternatively or in addition comprise a memory, a processor, or a combination thereof. The processor may be configured to perform respective tasks. A module in the present invention may alternatively or in addition be a distinct software tool or a part of a software tool, which preferably can be load to memory and/or can be executed, especially by the processor.

In preferred embodiments, the simulation module comprises a processor which is configured to perform respective FEM simulations of the meshed model of the real-world object, and/or it may comprise any commercially available simulation tool, such as a FEM simulation tool. In preferred embodiments, the first/second statistic module comprises a processor which is configured to perform statistical calculations, especially based on the values of the predefined parameters, and/or to provide corresponding first/second statistical data. The first and second statistic module may also be designed as one single module. In preferred embodiments, the machine learning module comprises a processor which comprises the trained machine learning model and/or which is configured to execute the trained machine learning model, especially to process the feature vector and/or to calculate the classification of the first vibrational mode, and/or to calculate the machine learning model from the input to the output.

The invention may make it obsolete that all the nodes of the mesh have to be manually inspected for classifying the type of the vibrational mode under inspection. Considering that a meshed version of a model often comprises several thousands to millions of nodes, it is apparent that with the proposed method much time can be saved. This is all the more true because for the manual differentiation between the vibrational mode types conventionally a lot of nodes per model have to be examined.

In one exemplary embodiment it is preferred that (i) the data of each geometric subdomain describes one or more local properties and/or states, such as displacement and/or strain energy, of the model, especially of the part of the model covered by the respective geometric subdomain, caused by the dynamic excitation, and/or (ii) the predefined parameters comprise the displacement of the respective nodes and/or the strain energy of the respective nodes.

These are preferred predefined parameters, since, both, the displacement and strain energy are characteristics of the individual nodes which can be used to reliably classify the type of the vibrational mode. Therefore, statistical data based on these characteristics provide useful information which can be used in the classification process of the first vibrational mode. In addition, the data can be obtained easily from the simulation, which is computational efficient.

In preferred embodiments the data of a geometric subdomain describes the local properties and/or states of at least that part of the model which is covered by the respective geometric subdomain. This allows to efficiently map the properties and states of the model to the geometric subdomains. For example, the data available for a certain part of the model (e.g. the data of the respective nodes of that part) may be used to obtain, such as calculate, the data of the geometric subdomain covering that part of the model.

In one exemplary embodiment it is preferred that for a selected set of nodes of the meshed version of the model, the respective values of the predefined parameters of that nodes contribute to the statistical data of a different number of geometric subdomains of the first and second set.

This is based on the finding that the inventive approach is particularly efficient and provides particularly reliable results if the individual first geometric subdomains of the first set do not fully align with the individual geometric subdomains of the second set. This allows that at least some geometric subdomains of the two sets representing the same local point of the model have assigned statistical data which is based on two different selections of nodes.

For example, the part of a meshed model corresponding to a specific part of the volume of the model of a real-world object may comprise 10 nodes. For carrying out the inventive approach, on the one hand, the specific part of the volume of the model may be completely covered by a single first geometric subdomain of the first set of first geometric subdomains (that first geometric subdomain may either cover also other parts of the volume of the model which are outside the specific part, or it may be exactly cover only that specific part). Hence, all 10 nodes contribute to the statistical data of that single first geometric subdomain (among other nodes, if applicable).

Further, the specific part of the volume of the model may be completely covered by two second geometric subdomains of the second set of second geometric subdomains (these second geometric subdomains may either cover also other parts of the volume of the model which are outside the specific part, or they may exactly cover only that specific part). Due to the shape, the size and/or the position of the two second geometric subdomains, 3 out of the 10 nodes may contribute to the statistical data of the first second geometric subdomain (among other nodes, if applicable), while 7 out of the 10 nodes may contribute to the statistical data of the second geometric subdomain (among other nodes, if applicable).

Furthermore, while in the example the set of 10 nodes contribute to the statistical data of only one single first geometric subdomain, it contributes to the statistical data of two second geometric subdomains. This mechanism allows to introduce a spatial distribution or mixing of the information obtained from the simulation, hence, different statistical data is provided. Since the two representations of different levels of detail provide for the same volume domain different statistical data, it turned out that the machine learning module is more efficient and provides more reliable results.

In one exemplary embodiment it is preferred that the data of each of the geometric subdomains, especially the statistical data of each of the first and/or second geometric subdomains, (i) is describing the movement of the respective geometric subdomain and/or (ii) comprises: the standard deviation of displacement, the minimal value of displacement, the maximal value of displacement, the mean value of displacement, the skewness of the values of displacement, the standard deviation of strain energy, the minimal value of strain energy, the maximal value of strain energy, the mean value of strain energy, the q-th quantile with several q numbers, and/or the skewness of the values of strain energy, respectively, of the nodes underlying the respective geometric subdomain and/or of the part of the model covered by the respective geometric subdomain.

Data describing the movement of the respective geometric subdomains is preferred because based on the movement a particularly precise and efficient classification of the mode can be carried out, especially by means of the machine learning module. This is true, as it turned out that the movement seems to be a particularly sensitive feature, especially for the machine learning module.

Displacement and strain energy may allow to determine the type of the vibrational mode in a reliable manner. Therefore, data, such as statistical data, based on these characteristics provide useful information which can be used in the classification process of the first vibrational mode. In addition, the data can be obtained easily from the simulation, which is computational efficient.

The movement may be described in that the statistical data for each geometric subdomain is calculated based on the displacement of the nodes underlying the respective geometric subdomains. For example, the mean value of the displacements of the nodes underlying a geometric subdomain may be the statistical data of that geometric subdomain.

Statistical data of each geometric subdomain may also comprise a mean value of the strain energy. This may be calculated based on the strain energy of the nodes underlying the respective geometric subdomains. For example, the mean value of the strain energy of the nodes underlying a geometric subdomain may be the statistical data in this respect of that geometric subdomain.

In one exemplary embodiment it is preferred that the total number of first and second geometric subdomains is less than the number of nodes of the meshed version of the model, especially the total number of first and second geometric subdomains is less than 80 %, preferably less than 50 %, more preferably less than 30 %, more preferably less than 10 %, more preferably less than 5 %, more preferably less than 1 %, more preferably less than 0.1 %, more preferably less than 0.01 %, of the number of nodes of the meshed version of the model; each of the first geometric subdomains has in average twice or more, preferably three times or more or four times or more, of the number of underlying nodes than each of the second geometric subdomains has; the average number of nodes underlying a first geometric subdomain of the first set of first geometric subdomains is larger than the average number of nodes underlying a second geometric subdomain of the second set of second geometric subdomains; the average number of nodes underlying a first geometric subdomain of the first set of geometric subdomains is 1 % or more, preferably 3 % or more, more preferably 5 % or more, of the total number of nodes of the meshed version of the model; and/or the average number of nodes underlying a second geometric subdomain of the second set of geometric subdomains is 5 % or less, preferably 3 % or less, more preferably 1 % or less, of the total number of nodes of the meshed version of the model.

It has been found that a particular efficient and reliable classification can be carried out and obtained, if the number of first geometric subdomains and/or the number of second geometric subdomains is chosen in light of the nodes of the meshed version of the model. This basically determines the size and the number of the geometric subdomains, at least in a relative manner with respect to the number of nodes. Indeed, these relations are also measure which are independent from the concrete model and its meshed version. Thus, the proposed relations can be used universally for different meshes. This makes the proposed method highly flexible and efficient.

If the relations are chosen in line with the invention and embodiments thereof, the information of the simulation results can be "distributed" spatially for the two sets of geometric subdomains in a manner which improves the classification quality.

Furthermore it has been found that the efficiency may be particularly improved by reducing the size of the feature vector. This may be easily accomplished in that the total number of first and second geometric subdomains (i.e. number of first geometric subdomains plus number of second geometric subdomains) is less than the number of nodes of the meshed version of the model as in conventionally approaches.

Moreover, since typically there are up to few millions of nodes and since the classification task is memory and CPU time consuming, incorporation of data of only a subset of elements in form of first and second geometric subdomains, rather than all nodes, an improved efficiency of the proposed method is obtained.

It has been found that the reduced amount of data can be compensated for, probably, due to the "interaction" between the two different representations of the model in form of two sets of geometric subdomains, especially in the machine learning module.

An appropriate ratio of, respectively, the first geometric subdomains and the respective underlying nodes and the second geometric subdomains and the respective underlying nodes allows to improve the effect of the statistical results. This is because the data, such as the statistical data, obtained for the first geometric subdomains then provides a more general view which is complemented with the more detailed view of the data obtained for the second geometric subdomains.

It has been turned out that the results are also improved if the average number of nodes underlying the first geometric subdomains is chosen appropriately compared to that of the second geometric subdomains.

However, the person skilled in the art knows that the number of geometric subdomains and/or nodes may depend on the original mesh parametrization and the shape of the 3D model that is parametrized. However, especially for modal analysis of vehicles, in a preferred embodiment it has been found beneficial to choose a regular set of voxels to be 3x3x4 or 4x4x4 and to choose the number of nodes to be between 100.000 and 5.000.000 nodes, especially depending on the vehicle model. In another preferred embodiment it has been found beneficial to choose an irregular set of voxels to be finer at the front and back of the vehicle model (both 3x3 voxels) and in the center 2x2 voxels.

In one exemplary embodiment it is preferred that the first level of detail is different to the second level of detail, preferably in that (i) the first set of first geometric subdomains is a representation of the real-world object which is more reduced in complexity than the second set of second geometric subdomains and/or (ii) the first set comprises a different number of geometric subdomains than the second set, especially the first set comprises less geometric subdomains than the second set.

Different levels of detail allow that the contribution of the simulation results (e.g. as obtained for the nodes) is different to the first set of geometric subdomains than to the second set of geometric subdomains. As a consequence, also the spatial distribution of the information of the simulation results is different for the two sets. It turned out that is highly beneficial for the accuracy of the classification, especially when carried out by the machine learning module.

For example, the first set of first geometric subdomains may provide a more general representation of the real-world object (or its model), while the second set of geometric subdomains may provide a more detailed representation of the real-world object (or its model). Hence, the second set of second geometric subdomains may then provide a more detailed view also on the effects the first vibrational mode has on individual areas of the object (or model). It turned out that based on such two representations and the data, such as the statistical data, associated with the respective first and second geometric subdomains, a particularly improved and reliable classification is possible.

If the first set comprises less geometric subdomains than the second set, the implementation may be made in an easy and efficient manner.

For example, the first set of first geometric subdomains may refer to an abstract representation of the model, say having only 10 geometric subdomains. The second set of second geometric subdomains may refer to a more detailed representation based on the structural parts of the model, say having 50 geometric subdomains. By way of example, the model may be a vehicle. The first set of first geometric subdomains may then be distributed across the model such that 1 first geometric subdomain represents the back, 1 first geometric subdomain represents the front, 2x2 first geometric subdomains represent the left and right side, 2 first geometric subdomains represent the roof and 2 first geometric subdomains represent the bottom, respectively, of the vehicle. The second set of second geometric subdomains may comprise said 50 geometric subdomains for representing the aforementioned parts, i.e. the back, the front, the left and right sides, the roof, and the bottom, respectively, of the vehicle. This allow that e.g. each of the sides of the vehicle may be represented by more than two second geometric subdomains (rather than just two as for the first set of geometric subdomains), such as one second geometric subdomain per wheel and two second geometric subdomains per door.

In one exemplary embodiment it is preferred that the geometric subdomains, especially the first geometric subdomains and/or the second geometric subdomains, comprise three-dimensional elements, especially tetrahedrons, quadrilateral pyramids, triangular prisms, hexahedrons, and/or polyhedrons.

Geometric subdomains of respective shapes may be beneficial since they may cover structures of interest more precise.

In a preferred exemplary embodiment, a geometric subdomain may also comprise two-dimensional elements, such as triangles and quadrilateral. But also other two-dimensional shapes, such as polygons, are possible.

Further, it is preferred that the first and/or second geometric subdomains may be any shaped subsets ("pieces") of the original geometry, i.e. of the model of the real-world object. This may comprise cube-like structures but also others or a combination thereof.

In one exemplary embodiment it is preferred that the first geometric subdomains are all of cubic shape and/or the second geometric subdomains are at least in part not of cubic shape.

Cubic geometric subdomains are computational inexpensive and, thus, improves efficiency of the method. Non-cubic second geometric subdomains allow to obtain a precise representation of a specific part of the object. It turned out that this allows to improve the quality of the results if the second level of detail is chosen at least in part accordingly.

In one exemplary embodiment it is preferred that the set of second geometric subdomains is chosen such that each of one or more specific parts of the model is exclusively represented by one or more distinct second geometric subdomains, especially the specific parts refer to functional elements of the real-world-object, for example the real-world-object being a vehicle and the specific parts are selected from the group comprising: roof, front, back, floor, left side, right side, interior and/or parts thereof, steering wheel, chassis, motor and/or parts thereof, rear and/or front axis with or without wheels, front left door, front right door, back left door, back right door, front left wheel, front right wheel, back left wheel and/or back right wheel.

This allows that each of the parts of the object, which are of particular interest, are represented by individual second geometric subdomains. Hence, no statistical data from other parts contribute to that parts. This allows that respective parts can be individually addressed and get more weight in the classification. This improves the quality of the classification.

In one exemplary embodiment it is preferred that obtaining the classification of the first vibrational mode comprises: obtaining, especially from the machine learning module, for each item of a predefined list of types of vibrational modes a probability value indicating the probability that the first vibrational mode corresponds to the type of vibrational mode of that item, wherein preferably the predefined list of types of vibrational modes comprises the items: local mode, global vertical bending mode, global horizontal bending mode, global torsion mode or any combination thereof.

These types of vibrational modes are particularly important for designing of real-world objects, especially for designing vehicles such as cars. Therefore, it is of great interest that they can be classified in a reliable manner.

Preferably, also a confidence bound may be received, especially from the machine learning module, for each probability value, which confidence bound indicates how reliable the respective probability value, hence, the classification is. The confidence bound may be a value between zero and one, whereby one may indicate very high confidence and zero may indicate very low confidence.

In one exemplary embodiment it is preferred that the machine learning model is trained using a plurality of feature vectors of vibrational modes and associated truth vectors indicating the type of the respective vibrational mode and/or the machine learning module comprises or is directed to a decision tree or a neuronal network.

A decision tree or a neuronal network allows a particularly efficient implementation of the machine learning module for carrying out the classification task. The approaches are predestinated for the classification task.

It turned out that the decision tree based classifier reaches a very high accuracy in differentiating between the different types of vibration modes, such as torsion mode, bending mode and local mode. Preferably, the decision tree comprises a machine learning model which in turn comprises random forest with 300-700, preferably 400-600, more preferably 500, trees, 150-350, preferably 200-300, more preferably 250, leaves and/or heavy L1 regularization.

Neuronal networks are highly flexible with respect to the number of first and second geometric subdomains and the assigned statistical data. Preferably, the neuronal network comprises a machine learning model which in turn comprises an input layer having a first plurality of neurons, at least one middle layer having a second plurality of neurons and an output layer having a third plurality of neurons, wherein preferably the number of the first plurality of neurons corresponds to the length of the feature vector, the number of the second plurality of neurons is between 2 and 500 neurons, preferably between 10 and 300 neurons, more preferably between 20 and 200 neurons, and/or the number of the third plurality of neurons corresponds to the length of the truth vector, i.e. the number of possible types of vibrational modes which can be classified.

A neuronal network, in preferred exemplary embodiments, is configured to find a correct mathematical manipulation to turn an input to the desired output, whether it is a linear relationship or a non-linear relationship. The network moves through its layers calculating the probability of each output. The network is trained with a set of sample data.

In one exemplary embodiment it is preferred that the simulation comprises a finite element method; the real-world object is a machine, such as a wind turbine, or a vehicle, such as a truck, a car, a train or an airplane, or a part thereof, such as a rotor blade of a wind turbine or a chassis of a vehicle, especially of a car; and/or the vibrational modes are caused by dynamic excitation comprising a sinusoidal excitation.

The finite element method (FEM) can be seen as the most widely used method for solving problems of engineering and mathematical models. The FEM is a particular numerical method for solving partial differential equations in two or three space variables. To solve a problem, the FEM subdivides a large system into smaller, simpler parts that are called finite elements. These elements are represented by the mesh.

Software modules for carrying out FEM simulation are commercially available. Thus, FEM is easy to implement. Especially, classifying the type of the vibrational modes which are obtained as a result of a simulation often is an important part during the design process of vehicles such as cars. However, the inventive approach is not limited to vehicle or vehicle bodies but can apply also to models of other real-world objects as well.

The dynamic excitation may be a sinusoidal excitation. This represent an excitation which allows to thoroughly analyze the model.

In one exemplary embodiment is preferred that the method further comprises:
Obtaining, especially from a modelling module, a 2D or 3D model of the real-world object, especially a 3D CAD model;
Obtaining, especially from a meshing module, a meshed version of the model, the meshed version of the model preferably comprising a plurality of nodes, especially with associated strain values, wherein preferably the strain values represent a spring between the nodes;
Carrying out, especially using the simulation module, a simulation of the real-world object under dynamic excitation based on the model, especially on the meshed version of the model, wherein preferably the results of the simulation comprise (i) a frequency spectrum which is indicative of all vibrational modes present for the simulated model and/or (ii) for each of the vibrational modes present for the simulated model values for one or more predefined parameters, such as displacement and/or strain energy, of each node of the meshed version of the model; Calculating, especially using a decision support module, a classification result output based on the classification of the first vibrational mode, especially as obtained from the machine learning module;
and/or
Outputting the classification result output and/or Controlling an entity, such as a module, based on the classification result output.

For example, a 3D model of the respective real-world object, or parts thereof, may be prepared. For example, a model may be directed to a chassis of a car. A model may also be directed to a complete car with a detailed representation of one or more parts of the entity, such as wheels, doors and the like. A CAD model is preferred since it allows to model different structures in an easily and efficient manner. Furthermore, it provides a convenient basis for carrying out the simulation.

For example, based on the model, a corresponding mesh grid, i.e. a meshed version of the model, may be produced, which comprises nodes and maybe also associated strains.

For example, a FEM simulation may be performed to solve numerically differential equations on the mesh grid of the model. For example, software packages such as NASTRAN may be employed for this task.

For example, a frequency spectrum may be obtained as a result from the FEM simulation. The individual vibrational modes which occur for the simulated model in the FEM simulation can then be identified in that spectrum by respective peaks. For each vibrational mode a classification result may be obtained. This may be based on the simulation results obtained for each node of the mesh, such as a value for the displacement, the strain energy and other values of predefined simulation parameters or a combination thereof.

In preferred exemplary embodiments, the modelling module and/or the meshing module in the present invention and exemplary embodiments thereof may be realized in software, in hardware, or a combination thereof. A module may alternatively or in addition comprise a memory, a processor, or a combination thereof. The processor may be configured to perform respective tasks. A module in the present invention may alternatively or in addition be a distinct software tool or a part of a software tool, which preferably can be load to memory and/or can be executed, especially by the processor.

In preferred exemplary embodiments, the modelling module comprises a processor which is configured to perform respective modelling of a 2D or 3D model of the real-world object. In preferred embodiments, the meshing module comprises a processor which is configured to perform respective meshing of the model.

It is beneficial, if the result obtained from the machine learning module can be further processed so as to obtain an appropriate representation of the classification in form of a classification result output. For example, the representation may be appropriate to control another entity such as another module.

Controlling a module or an entity based on the classification result output allows it in an efficient manner that further modules or entities are controlled based on the classification. For example, the model used for simulation may be adapted based on the classification. And a subsequent simulation and classification may then be carried out in order to improve the model, thus, the real-world object.

The problem is solved by the invention according to a second aspect in that a method for generating a training data set, which training data set preferably is or can be used for training the machine learning model comprised by the machine learning module in the method according to the first aspect of the invention, the method comprising:
Obtaining, especially from a simulation module, results of a simulation directed to a first vibrational mode present for a simulated model of a real-world object, wherein preferably the simulation results comprise values of one or more predefined parameters of each node of a meshed version of the model for that first vibrational mode;
Obtaining, especially from a first statistic module, for each first geometric subdomain of a first set of first geometric subdomains, which first set of first geometric subdomains represents the model in a first level of detail, one or more first statistical data based on the simulation results, preferably the first statistical data being based on the values of the predefined parameters, as comprised by the simulation results, of the nodes underlying the respective first geometric subdomain;
Obtaining, especially from a second statistic module, for each second geometric subdomain of a second set of second geometric subdomains, which second set of second geometric subdomains represents the model in a second level of detail, one or more second statistical data based on the simulation results, preferably the second statistical data being based on the values of the predefined parameters, as comprised by the simulation results, of the nodes underlying the respective second geometric subdomain;
Forming a feature vector comprising the first statistical data and/or the second statistical data; Providing a truth vector indicating the vibrational mode type of the first vibrational mode; and/or Associating the feature vector and the truth vector with each other;
and
Repeating the aforementioned for a plurality of first vibrational modes and/or for a plurality of simulations of the models of a plurality of real-world objects, to obtain a plurality of associated feature vectors and truth vectors representing a training data set is proposed.

It is has been found that a classification of the types of vibrational modes is particularly robust and reliable and of high quality if a machine learning module is employed for this task which has been trained with the proposed training data set.

Consequently, the inventive training data set provides a preferred basis in order to take all the advantages described above with respect to first aspect of the invention. Therefore, reference can be made to the statements provided above in this respect.

However, it is emphasized that an interesting aspect of the invention may be the finding that for the training data set, the data of different types of geometric subdomains is used, instead of data of local points, such as nodes. This specific preparation of the training data is particularly beneficial for improving the classification. In addition, this allows to reduce the amount of data. While the number of local points, such as nodes, may reach a few million, only a small number of geometric subdomains may be present, say 100 to 1000. It is an astonish finding that, thus, at the same time accuracy is even increased.

In principle it may be possible to train on different data objects (e.g. on different models of real-world objects) one big machine learning model. In case of limited data, it may be more efficient to train separate machine learning model for each object type.

The problem is solved by the invention according to a third aspect in that a method for training a machine learning model, preferably the machine learning model comprised by the machine learning module in the method according to the first aspect of the invention, the method comprising:
Providing a training data set comprising a plurality of associated feature vectors and truth vectors, wherein preferably the training data set is or can be obtained by the method according to the second aspect of the invention;
Registering the input of the machine learning model with a first feature vector from the training data set;
Calculating the machine learning model from the input to the output;
Comparing the output of the machine learning model with the truth vector associated with the first feature vector and determining of an error vector between both; and/or Amending the machine learning model based on the determined error vector;
and
Repeating the aforementioned for all other feature vectors and associated truth vectors from the training data set is proposed.

In preferred embodiments the random forest algorithm may be used. The error description is standard for machine learning models.

It has been found that a classification of the types of vibrational modes is particularly robust and reliable and of high quality if a machine learning module is employed for this task which has been trained in the proposed way.

Consequently, the proposed training method provides a preferred basis in order to take all the advantages described above with respect to the first aspect of the invention. Therefore, reference can be made to the statements provided above in this respect.

It turned out that the specific preparation of the feature vector may allow that the model converges more rapidly during training, which again increases the efficiency of the training. In principle it would be possible to train on different data objects (e.g. models of real-world objects) one big model. In case of limited data, it is more efficient to train separate model for each object type.

In preferred embodiments, the structure of the model may be a random forest model which is an ensemble of decision trees. In preferred embodiments, for the training process parallel training on GPU is possible.

In preferred exemplary embodiments, especially to ensure generalization of the model, the model may be trained in splits. For example, in the field of vehicles, the model may be trained on different type of cars, such as sedans, sport utility vehicles (SUVs) and/or Hatchbacks. For example, the model may be trained on sedans and tested on sport utility vehicles, and/or it may be trained on sport utility vehicles and Hatchback and tested on sedans. This may measure errors on the objects, that were not part of training and therefore may estimate a generalization error.

In preferred exemplary embodiments, a SHAP (SHapley Additive exPlanations) value algorithm may be applied to interpret feature interaction and feature contribution to the model prediction. This may help to build partial dependencies plot and check how increase/decrease of each feature value contributes to the model prediction. Since the model may estimate pseudo probability of classification, it is possible to post-process the model results based on model uncertainty. If a model is sure, say more than 90% in classification, the result may be taken as it is, while if model estimates maximum class probability of say 50-90 %, a human expert may be asked for feedback to check if prediction is right and if it is wrong, to correct it and include in training data and later retrain the model. This procedure may also be known as the so-called human-in-the-loop method.

Futhermore, the problem is solved by the invention according to a fourth aspect in that a real-world object which has been designed at least in part based on a classification of the type of at least one of the vibrational modes, which are obtained from a simulation of a model of the real-world object under dynamic excitation, according to the first aspect of the invention, especially the real-word object being a machine, such as a wind turbine, or a vehicle, such as a truck, a car, a train or an airplane, or a part thereof, such as a rotor blade of a wind turbine or a chassis of a vehicle, especially of a car is proposed.

It is a surprising finding, that real-world objects can be significantly improved in design, especially in their mechanical design, if the inventive approach for classification of the type of the vibrational modes is employed. Furthermore, also design costs are reduced.

The present invention and exemplary embodiments thereof may preferably be used in the field of automotive engineering.

Various aspects of this invention will become apparent to those skilled in the art from the following detailed description of preferred embodiments, when read in light of the accompanying schematic drawings, wherein
- Fig. 1a: shows a cross-section of a meshed version of a model of a real-world object;
- Fig. 1b: shows the cross-section of the meshed version of the model of the real-world
- object: along with a first set of first geometric subdomains;
- Fig. 1c: shows the cross-section of the meshed version of the model of the real-world object along with a second set of second geometric subdomains; and
- Fig. 2: shows a flow chart of a method according to the first aspect of the invention.

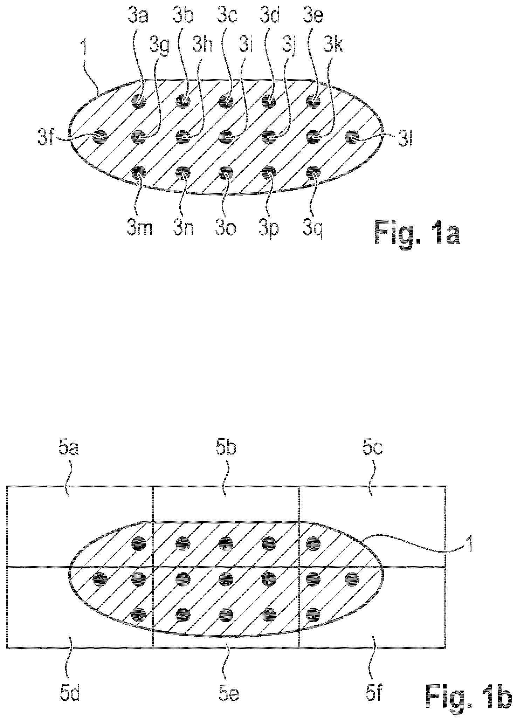

Fig. 1a shows a cross-section 1 of a meshed version of a model of a real-world object. The real-world object may be a chassis of a vehicle such as a car. The cross-section 1 which is indicated in Fig. 1a by a solid line and dotted area may lie in a plane which crosses a side part of the chassis.

The nodes 3a...3q are the (only) 17 nodes of the plurality of nodes comprised by the meshed version of the model which are lying within the cross-section 1. Commonly, nodes, such as the nodes 3a...3q are referred to as the nodes of the mesh. Of course, the meshed version of the model of the real-world object may comprise further nodes, which, however, do not lie within the cross-section 1.

The model of the real-world object can be divided into a first set of first geometric subdomains. Fig. 1b shows the cross-section 1 and the nodes 3a... 3q of Fig. 1a along with the first geometric subdomains 5a... 5f of the first set which have an intersection with the cross-section 1. For the sake of clarity, the nodes 3a... 3q have not been labeled in Fig. 1b, however, they can be identified by a comparison of Fig. 1b with Fig. 1a.

The nodes 3a...3q can be grouped so that each group comprises all nodes of cross-section 1 which are within a single first geometric subdomain 5a...5f. For example, node 3a forms the group of nodes of the first geometric subdomain 5a; nodes 3b, 3c and 3d forms the group of nodes of the first geometric subdomain 5b; and node 3e forms the group of nodes of the first geometric subdomain 5c. And so on.

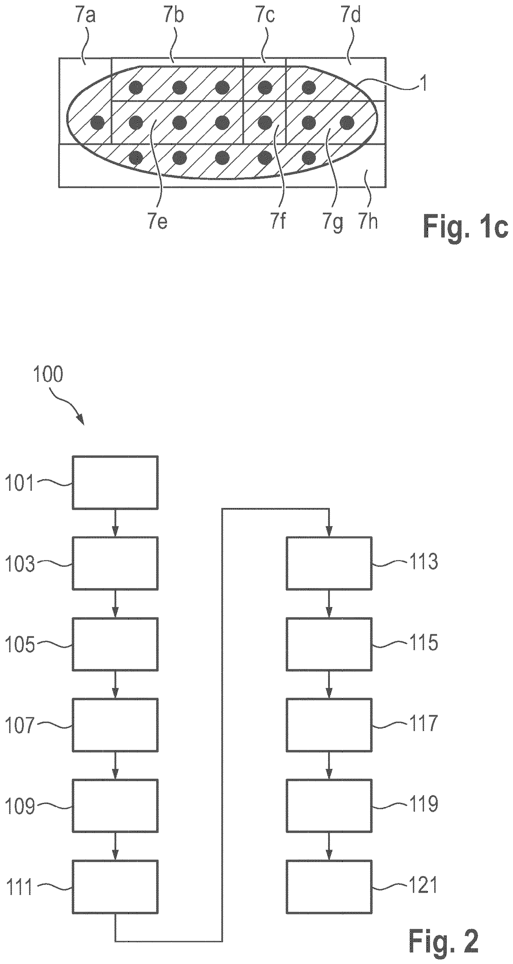

The model of the real-world object can also be divided into a second set of second geometric subdomains. Fig. 1c shows the cross-section 1 and the nodes 3a...3q of Fig. 1a along with the second geometric subdomains 7a...7h of the second set which have an intersection with the cross-section 1. For the sake of clarity, the nodes 3a...3q have not been labeled in Fig. 1c, however, they can be identified by a comparison of Fig. 1c with Fig. 1a.

The nodes 3a...3q can be grouped so that each group comprises all nodes of cross-section 1 which are within a single second geometric subdomain 7a...7h. For example, node 3f forms the group of nodes of the second geometric subdomain 7a; nodes 3a, 3b and 3c forms the group of nodes of the second geometric subdomain 7b; and node 3e forms the group of nodes of the second geometric subdomain 7d. And so on.

It is apparent from the description above in combination with Figs. 1a - 1c that for the cross-section 1 there can be found only one group of nodes (i.e. the group consisting of node 3e), which underly to the same number of geometric subdomains of the first and second set (i.e. to the one first geometric subdomain 5c of the first set and to the one second geometric subdomain 7d of the second set). All other groups of nodes have nodes which underly to a different number of geometric subdomains of the first and second set. For example, nodes 3a, 3b and 3c forms the group of nodes of the second geometric subdomain 7b. However, the nodes of that group underly (among others) the two first geometric subdomains 5a and 5b.

Assuming now that the real-world object (i.e. the chassis, a cross-section of which model is shown in Fig. 1a) under dynamic excitation now should be made subject to a simulation for modal analysis. The simulation is based on a meshed version of the model of that object under dynamic excitation. As a result of the simulation, different vibrational modes of the model of the object can be obtained. The vibrational modes then may be classified with respect to their type.

This classification task may be accomplished by a method according to the first aspect of the invention. Fig. 2 shows a flow chart of a respective method 100 according to the first aspect of the invention.

The method 100 is for classifying the type of at least one first vibrational mode of the vibrational modes which are obtained from a simulation of a model of a real-world object under dynamic excitation (a cross-section 1 of which model is shown in Fig. 1a). The simulation comprises a finite element method. The real-world object is the chassis of a car. And the vibrational modes are caused by dynamic excitation comprising a sinusoidal excitation.

The method comprises classifying the first vibrational mode based on data of a plurality of geometric subdomains of the model.

The plurality of geometric subdomains of the model comprises one or more first geometric subdomains of a first set of first geometric subdomains and one or more second geometric subdomains of a second set of second geometric subdomains, the first and second set of first and second geometric subdomains, respectively, represent the model in a first and second level of detail. And the data of each geometric subdomain is based at least in part on the results of the simulation.

In this respect the method 100 comprises:
101 indicates obtaining, from a modelling module, a 3D model of the real-world object. For example, this may be a CAD model of the real-world object. The model can be designed with any appropriate CAD software tool.
103 indicates obtaining, from a meshing module, a meshed version of the model, the meshed version of the model comprising a plurality of nodes (inter alia nodes 3a...3q) with associated strain values. The strain values represent a spring between the nodes and describe how the nodes are coupled with each other.
105 indicates carrying out, using a simulation module, a simulation of the real-world object under dynamic excitation based on the meshed version of the model.
107 indicates obtaining, from the simulation module, results of the simulation directed to the first vibrational mode present for the simulated model, wherein the simulation results comprise values of one or more predefined parameters of each node of the meshed version of the model for that first vibrational mode.

The predefined parameters comprise displacement and strain energy of the respective nodes. Thus, for each node (including nodes 3a... 3q), a value for the displacement and a value for the strain energy is obtained which characterized the first vibrational mode.

Indeed, the results of the simulation typically comprise a plurality of vibrational modes, the first vibrational mode being one of them. For example, the results of the simulation may comprise a frequency spectrum which is indicative of all vibrational modes present for the simulated model. Accordingly, the results of the simulation may comprise for each of the vibrational modes present for the simulated model respective values for the one or more predefined parameters of each node of the meshed version of the model.

109 indicates obtaining, from a first statistic module, for each first geometric subdomain of the first set of first geometric subdomains one or more first statistical data based on the simulation results, the first statistical data being based on the values of the predefined parameters, as comprised by the simulation results, of the nodes underlying the respective first geometric subdomain.

In the present embodiment, first statistical data assigned to the first geometric subdomain 5a is based on the values of the predefined parameters of the node 3a. In the present embodiment, first statistical data assigned to the first geometric subdomain 5b is based on the values of the predefined parameters of the nodes 3b... 3d. In the present embodiment first statistical data assigned to the first geometric subdomain 5f is based on the values of the predefined parameters of the nodes 3k, 3l and 3q. And so on (see also the description above and Figs. 1a and 1b). Of course, further nodes may contribute to the statistical data of the respective first geometric subdomains, which nodes, however, are not within the cross-section of Figs. 1a and 1b.

The statistical data is describing the movement of the respective first geometric subdomain. This may be expressed in that the statistical data comprise the mean value of displacement of the nodes underlying the respective first geometric subdomain.

111 indicates obtaining, from a second statistic module, for each second geometric subdomain of the second set of second geometric subdomains one or more second statistical data based on the simulation results, the second statistical data being based on the values of the predefined parameters, as comprised by the simulation results, of the nodes underlying the respective second geometric subdomain.

In the present embodiment, second statistical data assigned to the second geometric subdomain 7a is based on the values of the predefined parameters of the node 3f. In the present embodiment, second statistical data assigned to the second geometric subdomain 7b is based on the values of the predefined parameters of the nodes 3a, 3b and 3c. In the present embodiment, second statistical data assigned to the second geometric subdomain 7d is based on the values of the predefined parameters of the node 3e. And so on (see also description above and Figs. 1a and 1c). Of course, further nodes may contribute to the statistical data of the respective second geometric subdomains, which nodes, however, are not within the cross-section of Figs. 1a and 1c.

The statistical data is describing the movement of the respective second geometric subdomain. This may be expressed in that the statistical data comprise the mean value of displacement of the nodes underlying the respective second geometric subdomain.

It is apparent that for a selected set of nodes of the meshed version of the model, the respective predefined parameters of that nodes contribute to the statistical data of a different number of geometric subdomains of the first and second set. For example, let a selected set of nodes of the meshed version of the model be the nodes 3a, 3f, 3g and 3m (see Fig. 1a). These nodes contribute to the statistical data of the two first geometric subdomains 5a and 5d of the first set. But they contribute to the statistical data of the four second geometric subdomains 7a, 7b, 7e and 7h of the second set, i.e. twice as much.

See also the related discussion above with respect to the different group of nodes. The first level of detail is different to the second level of detail in that the first set comprises a different number of geometric subdomains than the second set, more precise, in that the first set comprises less geometric subdomains than the second set. This allows that the first set of first geometric subdomains is a representation of the real-world object which is more reduced in complexity than the second set of second geometric subdomains. Also in the drawing plane of Figs. 1b and 1c the second set of second geometric subdomains provides a more detailed representation than the first set of first geometric subdomains (of course, dependent on the chosen geometry and arrangement of the first and second geometric subdomains, this cannot be verified in all possible cross-sectional planes).

113 indicates forming a feature vector comprising the first statistical data and the second statistical data.

115 indicates processing, by a machine learning module, the feature vector to classify the type of the first vibrational mode, wherein the machine learning module comprises at least one trained machine learning model.

117 indicates obtaining, from the machine learning module, a classification of the first vibrational mode.

To be more precise, obtaining, from the machine learning module, the classification of the first vibrational mode comprises: Obtaining, from the machine learning module, for each item of a predefined list of types of vibrational modes a probability value indicating the probability that the first vibrational mode corresponds to the type of vibrational mode of that item.

In the present embodiment, the predefined list of types of vibrational modes comprises the items: local mode, global vertical bending mode, global horizontal bending mode and global torsion mode.

This means, that for the first vibrational mode the output of the machine learning module in 117 may be similar to the following form, where for each item of the predefined list of types of vibrational modes a probability value indicating the probability that the first vibrational mode corresponds to the type of vibrational mode of that item is provided:
Local mode = 1.38 %; Global vertical bending mode = 96.84 %; Global horizontal bending mode = 1.23 %; Global torsion mode = 0.55 %.

Such a result indicates that the first vibrational mode most probably is of the type of a global vertical bending mode, since it has a probability value of 96.84 %, which is the highest one in the list. In contrast, the probability for example that the first vibrational mode is of the type of a global torsion mode has only a value of 0.55 %.

119 indicates calculating, using a decision support module, a classification result output based on the classification of the first vibrational mode as obtained from the machine learning module.

121 indicates outputting the classification result output and/or to controlling an entity, such as a module, based on the classification result output.

### List of Reference Signs

- 1: Cross-Section
- 3a - 3q: Node
- 5a - 5f: Fist geometric subdomain
- 7a - 7h: Second geometric subdomain
- 100: Method
- 101: Obtaining, from a modelling module, a 3D model of the real-world object
- 103: Obtaining, from a meshing module, a meshed version of the model, the meshed version of the model comprising a plurality of nodes with associated strain values
- 105: Carrying out, using a simulation module, a simulation of the real-world object under dynamic excitation based on the meshed version of the model
- 107: Obtaining, from the simulation module, results of the simulation directed to the first vibrational mode present for the simulated model, wherein the simulation results comprise values of one or more predefined parameters of each node of the meshed version of the model for that first vibrational mode
- 109: Obtaining, from a first statistic module, for each first geometric subdomain of the first set of first geometric subdomains one or more first statistical data based on the simulation results, the first statistical data being based on the values of the predefined parameters, as comprised by the simulation results, of the nodes underlying the respective first geometric subdomain
- 111: Obtaining, from a second statistic module, for each second geometric subdomain of the second set of second geometric subdomains one or more second statistical data based on the simulation results, the second statistical data being based on the values of the predefined parameters, as comprised by the simulation results, of the nodes underlying the respective second geometric subdomain
- 113: Forming a feature vector comprising the first statistical data and the second statistical data
- 115: Processing, by a machine learning module, the feature vector to classify the type of the first vibrational mode, wherein the machine learning module comprises at least one trained machine learning model
- 117: Obtaining, from the machine learning module, a classification of the first vibrational mode
- 119: Calculating, using a decision support module, a classification result output based on the classification of the first vibrational mode as obtained from the machine learning module
- 121: Outputting the classification result output and/or controlling an entity, such as a module, based on the classification result output

## Claims

1. Method (100) for classifying the type of at least one first vibrational mode of the vibrational modes which are obtained from a simulation of a model of a real-world object under dynamic excitation, the method comprising classifying the first vibrational mode based on data of a plurality of geometric subdomains of the model;
wherein the plurality of geometric subdomains of the model comprises one or more first geometric subdomains (5a-5f) of a first set of first geometric subdomains and one or more second geometric subdomains (7a-7h) of a second set of second geometric subdomains, the first and second set of first and second geometric subdomains, respectively, represent the model in a first and second level of detail; and wherein the data of each geometric subdomain is based at least in part on the results of the simulation.

2. Method according to claim 1, the method comprising:
- Obtaining (107), especially from a simulation module, results of the simulation directed to the first vibrational mode present for the simulated model, wherein preferably the simulation results comprise values of one or more predefined parameters of each node (3a-3q) of a meshed version of the model for that first vibrational mode;
- Obtaining (109), especially from a first statistic module, for each first geometric subdomain of the first set of first geometric subdomains, one or more first statistical data based on the simulation results, preferably the first statistical data being based on the values of the predefined parameters, as comprised by the simulation results, of the nodes underlying the respective first geometric subdomain;
- Obtaining (111), especially from a second statistic module, for each second geometric subdomain of the second set of second geometric subdomains, one or more second statistical data based on the simulation results, preferably the second statistical data being based on the values of the predefined parameters, as comprised by the simulation results, of the nodes underlying the respective second geometric subdomain;
- Forming (113) a feature vector comprising the first statistical data and/or the second statistical data;
- Processing (115), especially by a machine learning module, the feature vector to classify the type of the first vibrational mode, wherein preferably the machine learning module comprises at least one trained machine learning model;
and/or
- Obtaining (117), especially from the machine learning module, a classification of the first vibrational mode.

3. Method according to claim 1 or 2, wherein
(i) the data of each geometric subdomain describes one or more local properties and/or states, such as displacement and/or strain energy, of the model, especially of the part of the model covered by the respective geometric subdomain, caused by the dynamic excitation, and/or
(ii) the predefined parameters comprise the displacement of the respective nodes and/or the strain energy of the respective nodes.

4. Method according to claim 2 or 3, wherein
for a selected set of nodes of the meshed version of the model, the respective values of the predefined parameters of that nodes contribute to the statistical data of a different number of geometric subdomains of the first and second set.

5. Method according to any one of the preceding claims, wherein
the data of each of the geometric subdomains, especially the statistical data of each of the first and/or second geometric subdomains, (i) is describing the movement of the respective geometric subdomain and/or (ii) comprises:
the standard deviation of displacement,
the minimal value of displacement,
the maximal value of displacement,
the mean value of displacement,
the skewness of the values of displacement,
the standard deviation of strain energy,
the minimal value of strain energy,
the maximal value of strain energy,
the mean value of strain energy,
the q-th quantile with several q numbers, and/or
the skewness of the values of strain energy,
respectively, of the nodes underlying the respective geometric subdomain and/or of the part of the model covered by the respective geometric subdomain.

6. Method according to any one of the claims 2 to 5, wherein
- the total number of first and second geometric subdomains is less than the number of nodes of the meshed version of the model, especially the total number of first and second geometric subdomains is less than 80 %, preferably less than 50 %, more preferably less than 30 %, more preferably less than 10 %, more preferably less than 5 %, more preferably less than 1 %, more preferably less than 0.1 %, more preferably less than 0.01 %, of the number of nodes of the meshed version of the model;
- each of the first geometric subdomains has in average twice or more, preferably three times or more or four times or more, of the number of underlying nodes than each of the second geometric subdomains has;
- the average number of nodes underlying a first geometric subdomain of the first set of first geometric subdomains is larger than the average number of nodes underlying a second geometric subdomain of the second set of second geometric subdomains;
- the average number of nodes underlying a first geometric subdomain of the first set of geometric subdomains is 1 % or more, preferably 3 % or more, more preferably 5 % or more, of the total number of nodes of the meshed version of the model;
and/or
- the average number of nodes underlying a second geometric subdomain of the second set of geometric subdomains is 5 % or less, preferably 3 % or less, more preferably 1 % or less, of the total number of nodes of the meshed version of the model.

7. Method according to any one of the preceding claims, wherein
the first level of detail is different to the second level of detail, preferably in that (i) the first set of first geometric subdomains is a representation of the real-world object which is more reduced in complexity than the second set of second geometric subdomains and/or (ii) the first set comprises a different number of geometric subdomains than the second set, especially the first set comprises less geometric subdomains than the second set.

8. Method according to any one of the preceding claims, wherein
the geometric subdomains, especially the first geometric subdomains and/or the second geometric subdomains, comprise three-dimensional elements, especially tetrahedrons, quadrilateral pyramids, triangular prisms, hexahedrons, and/or polyhedrons.

9. Method according to any one of the preceding claims, wherein
the first geometric subdomains are all of cubic shape and/or the second geometric subdomains are at least in part not of cubic shape.

10. Method according to any one of the preceding claims, wherein
the set of second geometric subdomains is chosen such that each of one or more specific parts of the model is exclusively represented by one or more distinct second geometric subdomains, especially the specific parts refer to functional elements of the real-world-object, for example the real-world-object being a vehicle and the specific parts are selected from the group comprising: roof, front, back, floor, left side, right side, interior and/or parts thereof, steering wheel, chassis, motor and/or parts thereof, rear and/or front axis with or without wheels, front left door, front right door, back left door, back right door, front left wheel, front right wheel, back left wheel and/or back right wheel.

11. Method according to any one of the claims 2 to 10, wherein obtaining the classification of the first vibrational mode comprises:
obtaining, especially from the machine learning module, for each item of a predefined list of types of vibrational modes a probability value indicating the probability that the first vibrational mode corresponds to the type of vibrational mode of that item,
wherein preferably the predefined list of types of vibrational modes comprises the items:
local mode, global vertical bending mode, global horizontal bending mode, global torsion mode or any combination thereof.

12. Method according to any one of the claims 2 to 11, wherein
the machine learning model is trained using a plurality of feature vectors of vibrational modes and associated truth vectors indicating the type of the respective vibrational mode and/or the machine learning module comprises or is directed to a decision tree or a neuronal network.

13. Method according to any one of the preceding claims, wherein
the simulation comprises a finite element method; the real-world object is a machine, such as a wind turbine, or a vehicle, such as a truck, a car, a train or an airplane, or a part thereof, such as a rotor blade of a wind turbine or a chassis of a vehicle, especially of a car; and/or the vibrational modes are caused by dynamic excitation comprising a sinusoidal excitation.

14. Method according to any one of the preceding claims, wherein the method further comprises:
- Obtaining (101), especially from a modelling module, a 2D or 3D model of the real-world object, especially a 3D CAD model;
- Obtaining (103), especially from a meshing module, a meshed version of the model, the meshed version of the model preferably comprising a plurality of nodes, especially with associated strain values, wherein preferably the strain values represent a spring between the nodes;
- Carrying out (105), especially using the simulation module, a simulation of the real-world object under dynamic excitation based on the model, especially on the meshed version of the model,
- wherein preferably the results of the simulation comprise (i) a frequency spectrum which is indicative of all vibrational modes present for the simulated model and/or (ii) for each of the vibrational modes present for the simulated model values for one or more predefined parameters, such as displacement and/or strain energy, of each node of the meshed version of the model;
- Calculating (119), especially using a decision support module, a classification result output based on the classification of the first vibrational mode, especially as obtained from the machine learning module;
and/or
- Outputting (121) the classification result output and/or Controlling an entity, such as a module, based on the classification result output.

15. Real-world object which has been designed at least in part based on a classification of the type of at least one of the vibrational modes, which are obtained from a simulation of a model of the real-world object under dynamic excitation, according to any one of the claims 1 to 14,
wherein the real-word object being
- a machine, such as a wind turbine, or
- a vehicle, such as a truck, a car, a train or an airplane, or a part thereof, such as a rotor blade of a wind turbine or a chassis of a vehicle, in particular a part of a car.
